# EUROPEAN PATENT APPLICATION

(11) **EP 4 726 685 A1**
(43) Date of publication of application: **15.04.2026**
(21) Application number: 25201285.1
(22) Date of filing: 10.09.2025
(51) Int. Cl.: G07C 5/08, B64F 5/60

(54) **DATA RECORDERS**

(30) Priority: 10.10.2024 GB 202414890
(71) Applicant: Rolls-Royce plc, London N1 9FX (GB)
(72) Inventor: Leonard, Joe S, Derby, DE24 8BJ (GB); Sekaran, Paulas R, Derby, DE24 8BJ (GB)
(74) Representative: Rolls-Royce plc

(57) **Abstract**

A data recorder comprising: at least one processor; at least one memory comprising computer readable instructions; the at least one processor being configured to read the computer readable instructions to cause performance of: receiving one or more of: sensor configuration data; or sensor calibration data from a memory of a connector connected between the data recorder and a sensor; reading the connector to receive a digital signal; processing the received digital signal; and controlling storage of data in the processed digital signal in the at least one memory of the data recorder.

## Description

### FIELD

This disclosure relates to data recorders.

### BACKGROUND

Vehicles, such as aircraft, usually include one or more propulsion systems (for example, a heat engine such as a gas turbine engine or a reciprocating engine) for providing thrust and/or electrical power to the propulsion system and vehicle. An equipment health monitoring system may be integrated within the propulsion system and/or the vehicle to enable various parameters (such as pressures, temperatures, and vibrations) of the propulsion system to be monitored. However, such equipment health monitoring systems may add weight to the vehicle, and may increase the fuel consumption of the vehicle when in operation (when flying between airports for example).

### SUMMARY

According to a first aspect there is provided a data recorder comprising: at least one processor; at least one memory comprising computer readable instructions; the at least one processor being configured to read the computer readable instructions to cause performance of: receiving one or more of: sensor configuration data; or sensor calibration data from a memory of a connector connected between the data recorder and a sensor; reading the connector to receive a digital signal; processing the received digital signal; and controlling storage of data in the processed digital signal in the at least one memory of the data recorder.

The connector may comprise reading the connector using the received sensor configuration data to receive the digital signal.

Processing the received digital signal may comprise processing the received digital signal using the received sensor calibration data.

The data recorder may further comprise controlling storage of sensor history data in the memory of the connector.

The data recorder may further comprise an isolator configured to electrically connect to the connector.

The at least one processor may be configured to read the computer readable instructions to cause performance of: determining whether the connector is electrically connected to the data recorder; controlling the isolator to electrically disconnect in response to determining that the connector is not electrically connected to the data recorder; and controlling the isolator to electrically connect in response to determining that the connector is electrically connected to the data recorder.

The data recorder may further comprise a transmitter configured to transmit the stored data from the data recorder.

The transmitter may be configured to transmit the stored data wirelessly.

The at least one memory may be hand removable from the data recorder by a person.

According to a second aspect there is provided a system comprising: the data recorder as described in any of the preceding paragraphs; and a connector connecting a sensor to the data recorder, the connector comprising: circuitry configured to receive a signal from the sensor and to transmit a digital signal to the data recorder; and a memory storing the one or more of: the sensor configuration data; or the sensor calibration data.

The memory of the connector may store sensor history data.

The circuitry of the connector may comprise: an analogue front-end configured to: receive an analogue signal from the sensor, and perform signal conditioning on the analogue signal; and an analogue to digital converter configured to: receive the conditioned analogue signal from the analogue front-end, and convert the conditioned analogue signal into the digital signal.

The connector may further comprise a first contact connected to the analogue front-end, the first contact being connected to the sensor via a cable.

The connector may further comprise a second contact connected to the analogue to digital converter, and to the memory. The second contact may be configured to electrically connect to the data recorder.

The second contact may be connected to the memory.

The circuitry may further comprise a processor connected to the analogue to digital converter and to the memory. The connector may further comprise a second contact connected to the processor.

The second contact may comprise a plurality of contact pins electrically connected to the data recorder.

At least one contact pin of the plurality of contact pins may be configured to confirm an electrical connection between the data recorder and the connector.

The system may further comprise a housing defining a cavity. The circuitry and the memory of the connector may be positioned within the cavity of the housing of the connector.

The system may further comprise: a hub comprising: a housing defining a cavity; and a plurality of connectors, the plurality of connectors being positioned within the cavity of the housing of the hub, each of the plurality of connectors comprising: circuitry configured to receive a signal from the sensor and to transmit a digital signal to the data recorder; and a memory storing the one or more of: the sensor configuration data; or the sensor calibration data.

The hub may further comprise a bus extender connected to the plurality of connectors.

The system may further comprise a sensor connected to the connector.

The sensor may be connected to the connector via a cable.

According to a third aspect there is provided a propulsion system comprising the system described in any of the preceding paragraphs.

According to a fourth aspect there is provided a computer-implemented method comprising: receiving one or more of: sensor configuration data or sensor calibration data from a memory of a connector connected to a sensor; reading the connector to receive a digital signal; processing the received digital signal; and controlling storage of data in processed digital signal in a memory of a data recorder.

Reading the connector may comprise reading the connector using the received sensor configuration data to receive the digital signal.

Processing the received digital signal may comprise processing the received digital signal using the received sensor calibration data.

The computer-implemented method may further comprise controlling storage of sensor history data in the memory of the connector.

The computer-implemented method may further comprise: determining whether the connector is electrically connected to the data recorder; controlling an isolator to electrically disconnect in response to determining that the connector is not electrically connected to the data recorder; and controlling the isolator to electrically connect in response to determining that the connector is electrically connected to the data recorder.

The computer-implemented method may further comprise controlling a transmitter to transmit the stored data from the data recorder.

According to a fifth aspect there is provided a connector for connecting a sensor to a data recorder, the connector comprising: circuitry configured to receive a signal from the sensor and to transmit a digital signal to the data recorder; and a memory storing one or more of: sensor configuration data or sensor calibration data.

The memory may store sensor history data.

The circuitry may comprise: an analogue front-end configured to: receive an analogue signal from the sensor, and perform signal conditioning on the analogue signal; and an analogue to digital converter configured to: receive the conditioned analogue signal from the analogue front-end, and convert the conditioned analogue signal into the digital signal.

The connector may further comprise a first contact connected to the analogue front-end. The first contact may be configured to connect to the sensor via a cable.

The connector may further comprise a second contact connected to the analogue to digital converter. The second contact may be configured to electrically connect to a data recorder.

The second contact may be connected to the memory.

The circuitry may further comprise a processor connected to the analogue to digital converter and to the memory. The connector may further comprise a second contact connected to the processor.

The second contact may comprise a plurality of contact pins configured to electrically connect to the data recorder.

At least one contact pin of the plurality of contact pins may be configured to confirm an electrical connection between the data recorder and the connector.

The connector may further comprise a housing defining a cavity. The circuitry and the memory may be positioned within the cavity of the housing of the connector.

According to a sixth aspect there is provided a hub comprising: a housing defining a cavity; and a plurality of connectors as described in any of the preceding paragraphs, the plurality of connectors being positioned within the cavity of the housing of the hub.

The hub may further comprise a bus extender connected to the plurality of connectors.

According to a seventh aspect there is provided a system comprising: the connector as described in any of the preceding paragraphs; and a sensor connected to the connector.

The sensor may be connected to the connector via a cable.

The system may further comprise a data recorder. The connector may be electrically connected to the data recorder.

The data recorder may comprise: at least one processor; at least one memory comprising computer readable instructions; the at least one processor being configured to read the computer readable instructions to cause performance of: receiving one or more of: sensor configuration data or sensor calibration data from the memory of the connector; reading the connector to receive the digital signal; processing the received digital signal; and controlling storage of data in the processed digital signal in the at least one memory of the data recorder.

Reading the connector may comprise reading the connector using the received sensor configuration data to receive the digital signal.

Processing the received digital signal may comprise processing the received digital signal using the received sensor calibration data.

The data recorder may further comprise an isolator configured to electrically connect to the connector.

The at least one processor may be configured to read the computer readable instructions to cause performance of: determining whether the connector is electrically connected to the data recorder; controlling the isolator to electrically disconnect in response to determining that the connector is not electrically connected to the data recorder; and controlling the isolator to electrically connect in response to determining that the connector is electrically connected to the data recorder.

The system may further comprise a transmitter configured to transmit the stored data from the data recorder.

The transmitter may be configured to transmit the stored data wirelessly.

The at least one memory of the data recorder may be hand removable from the data recorder by a person.

According to an eighth aspect there is provided a propulsion system comprising the system as described in any of the preceding paragraphs.

### BRIEF DESCRIPTION OF THE DRAWINGS

Embodiments will now be described by way of example only with reference to the accompanying drawings, in which:
FIG. 1 illustrates a diagram of a connector according to a first example;
FIG. 2 illustrates a diagram of a connector according to a second example;
FIG. 3 illustrates a diagram of a connector according to a third example;
FIG. 4 illustrates a diagram of a connector according to a fourth example;
FIG. 5 illustrates a diagram of a connector according to a fifth example;
FIG. 6 illustrates a front view of the second contact of the connector illustrated in FIG. 5 according to an example;
FIG. 7 illustrates a diagram of a hub according to an example;
FIG. 8 illustrates a diagram of a data recorder according to an example;
FIG. 9 illustrates a diagram of a system according to an example;
FIG. 10 illustrates a diagram of a propulsion system according to an example;
FIG. 11 illustrates a flow diagram of a method according to a first example; and
FIG. 12 illustrates a flow diagram of a method according to a second example.

### DETAILED DESCRIPTION

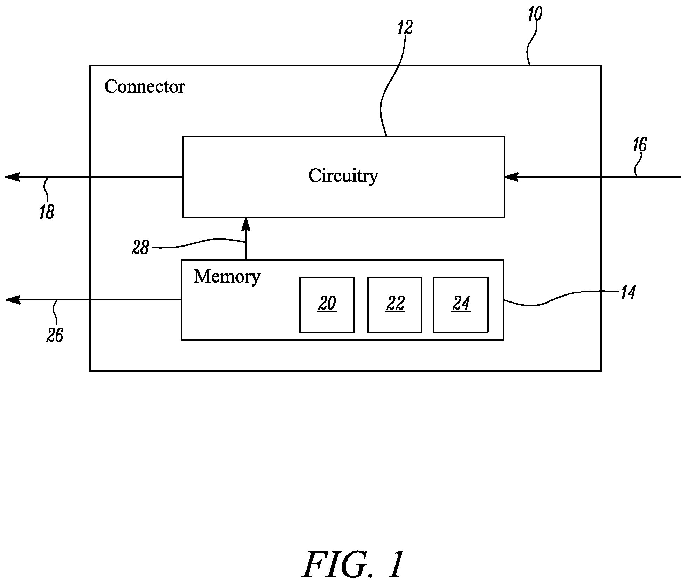

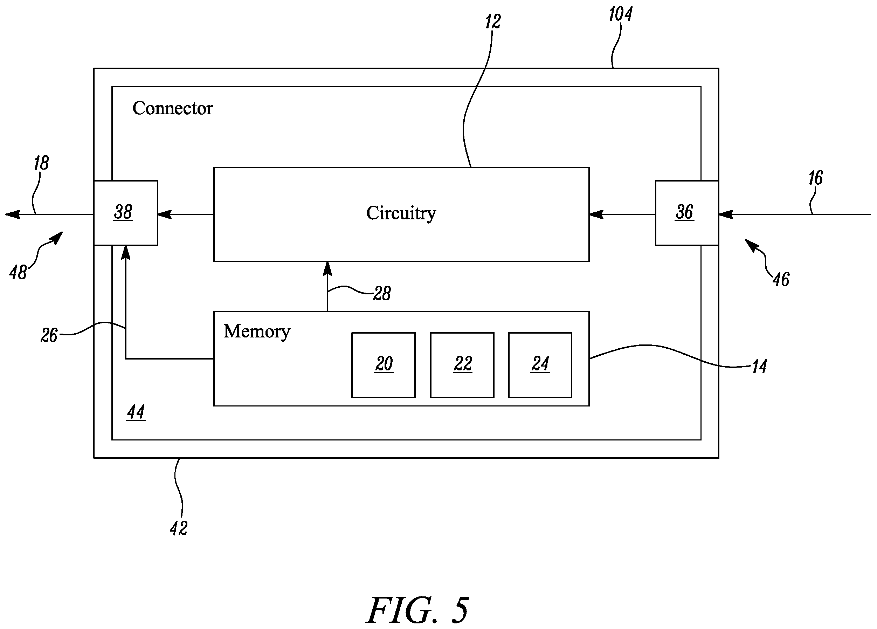

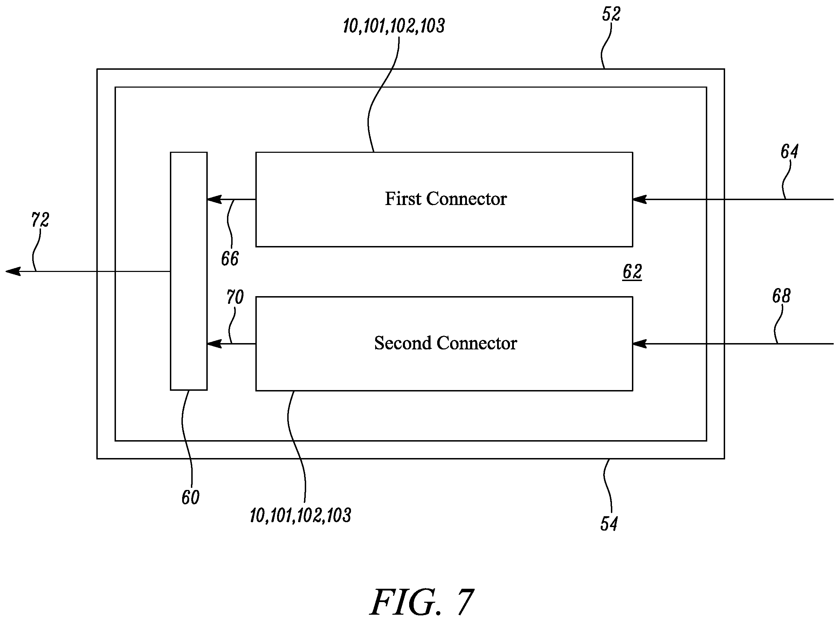

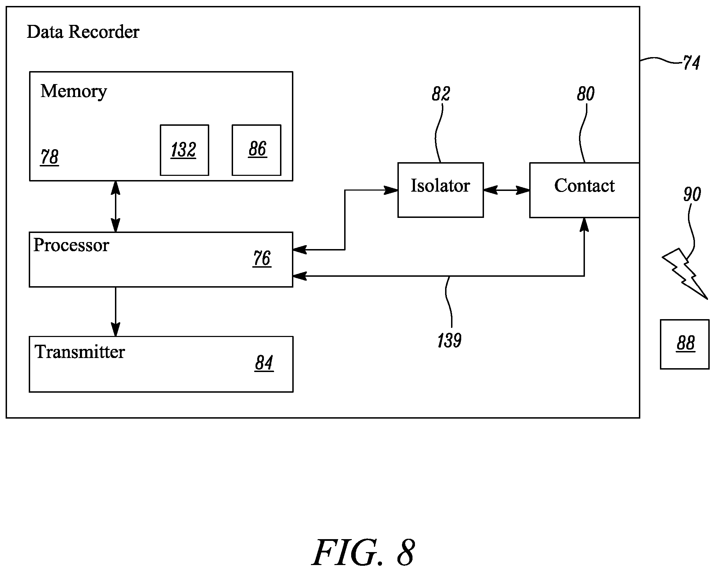

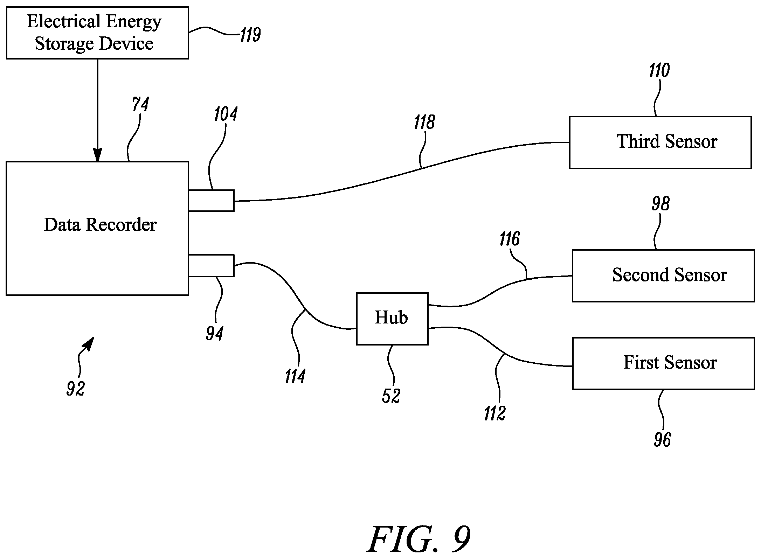

FIG. 1 illustrates a diagram of a connector 10 for connecting a sensor to a data recorder. The connector 10 stores data (e.g., calibration data) which may be read by the data recorder to facilitate the operation of the sensor with the data recorder. The connector 10 may be a discrete electronic device (such as a plug) where the components of the connector 10 are housed by a housing of the connector (as illustrated in FIG. 5 for example). Alternatively, the connector 10 may be a part of another device (such as a hub) where the components of the connector 10 are housed by a housing of the other device (as illustrated in FIG. 7 for example). The data recorder and the sensor are described in greater detail below with reference to FIGS. 8 and 9 respectively.

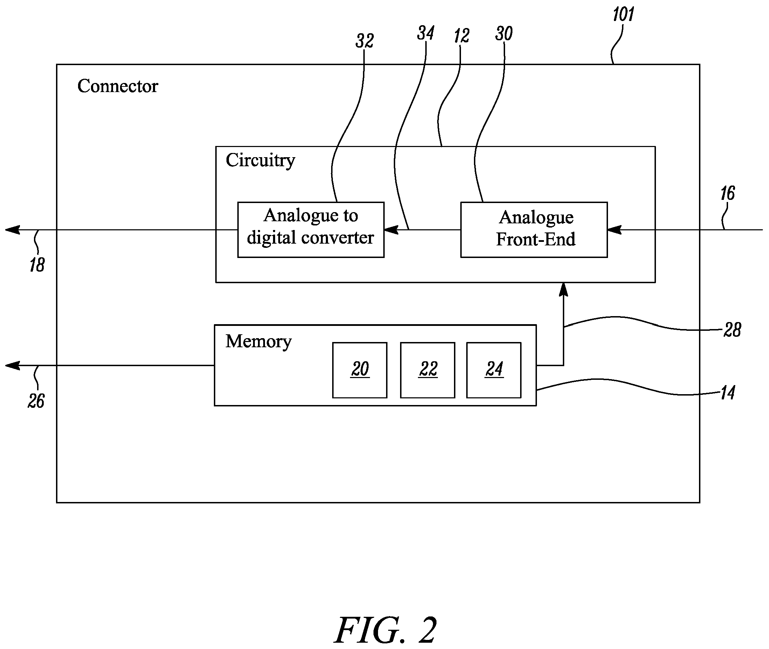

The connector 10 includes circuitry 12 and a memory 14. The circuitry 12 is configured to receive a signal 16 from the sensor and to transmit a digital signal 18 to the data recorder. The signal 16 may be an analogue signal or may be a digital signal. In examples where the signal 16 is a digital signal, the circuitry 12 may not modify the signal 16 and consequently, the circuitry 12 may be an electrical wire, an electrical cable or a printed circuit board (PCB) trace. In other examples, the circuitry 12 may modify the signal 16 and may consequently comprise one or more electronic components for performing the modification (as described below with reference to FIGS. 2 to 4).

The memory 14 may be any suitable non-transitory computer readable storage medium, data storage device or devices, and may comprise a hard disk and/or solid-state memory (such as flash memory). The memory 14 may be permanent non-removable memory, or may be removable memory (such as a secure digital card). The memory 14 stores one or more of: sensor configuration data 20; or sensor calibration data 22. The memory 14 may also store sensor history data 24. The data recorder may read the data 20, 22, 24 directly from the memory 14 (as indicated by arrow 26 in FIG. 1), or may read the data 20, 22, 24 via the circuitry 12 (as indicated by arrow 28 in FIG. 1).

The sensor configuration data 20 defines settings for the sensor and may define how the sensor is to be read by the data recorder. For example, the sensor configuration data 20 may define a frequency at which the sensor is to be read by the data recorder (e.g., readings at 1 Hz). By way of another example, the sensor configuration data 20 may define a calibration interval for the sensor (that is, a maximum time period between calibrations of the sensor). The sensor configuration data 20 may also define protocol, filter settings (analogue/digital), excitation (voltage, current, AC), sample rates, resolution (e.g., may reduce unnecessary resolution to reduce memory usage).

The sensor calibration data 22 defines how data generated by the sensor is to be modified (with the aim of improving the accuracy of the sensor generated data). For example, the sensor calibration data 22 may define that sensor generated data be modified by a fixed value (through addition, subtraction, multiplication, or division for example). By way of another example, the sensor calibration data 22 may define that sensor generated data be modified according to a linear or non-linear algorithm. The sensor calibration data 22 may also comprise coefficients for turning binary data into engineering units (EU) and contains limits, e.g., amplitude limits on a vibration sensor, temperature compensation etc.

The sensor history data 24 is a record of the history of the sensor. For example, the sensor history data 24 may record one or more dates on which the sensor calibration data 22 was modified. By way of another example, the sensor history data 24 may record one or more dates on which the sensor configuration data 20 was modified.

FIG. 2 illustrates a diagram of a connector 101 for connecting a sensor to a data recorder according to a second example. The connector 101 is similar to the connector 10 and where the features are similar, the same reference numerals are used. The connector 101 includes circuitry 12 and memory 14 storing one or more of: sensor configuration data 20; or sensor calibration data 22 (the memory 14 may also store sensor history data 24). The circuitry 12 includes an analogue front-end 30 and an analogue to digital converter 32.

The analogue front-end 30 may comprise any suitable circuitry and may comprise, for example, one or more of: an operational amplifier; a filter; an application-specific integrated circuit (ASIC); or a field programmable gate array (FPGA). The analogue front-end 30 is configured to receive the analogue signal 16 from the sensor and perform signal conditioning on the analogue signal 16. For example, the analogue front-end 30 may perform one of more of: voltage limiting; current limiting; or anti-aliasing filtering, on the analogue signal 16 to provide a conditioned analogue signal 34.

The analogue to digital converter (ADC) 32 may comprise any suitable circuitry and may comprise, for example, an integrated circuit such as a metal-oxide-semiconductor (MOS) mixed-signal integrated circuit. The analogue to digital converter 32 may be a Sigma-Delta ADC, a Successive Approximation ADC, or a Continuous Time Sigma-Delta ADC. The analogue to digital converter 32 is configured to receive the conditioned analogue signal 34 from the analogue front-end 30, and to convert the conditioned analogue signal into the digital signal 18.

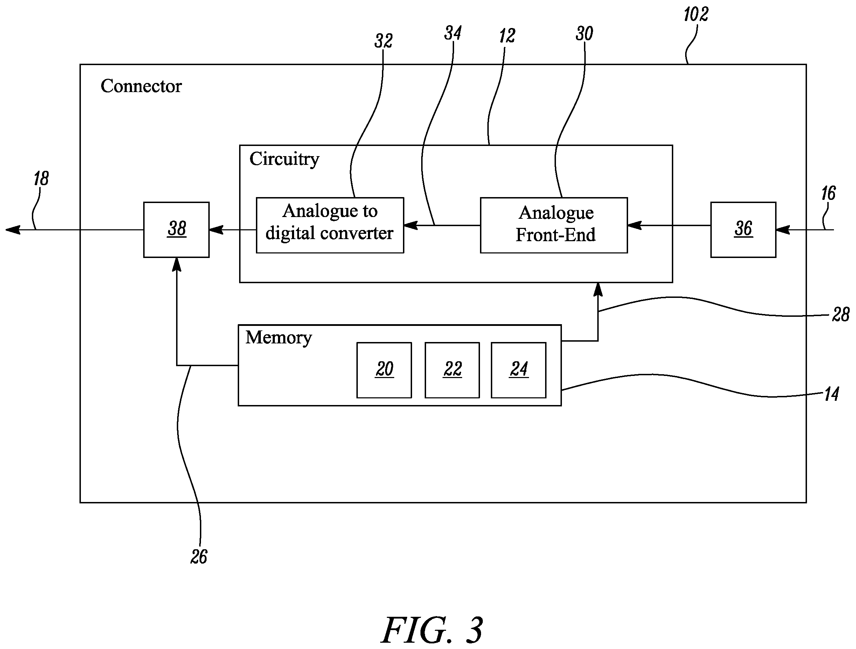

FIG. 3 illustrates a diagram of a connector 102 for connecting a sensor to a data recorder according to a third example. The connector 102 is similar to the connectors 10, 101 and where the features are similar, the same reference numerals are used. The connector 102 includes circuitry 12 comprising an analogue front-end 30 and an analogue to digital converter 32, and memory storing one or more of: sensor configuration data 20; or sensor calibration data 22. The memory 14 may also store sensor history data 24. The connector 102 also includes a first contact 36 and a second contact 38.

The first contact 36 is connected to the analogue front-end 30 and is configured to connect to the sensor via a cable. The first contact 36 may comprise an electrically conductive pad or vise to connect to the cable and to enable reception of an electrical signal from the sensor. In some examples, the first contact 36 may comprise a photodiode to enable reception of an optical signal from an optical fibre cable.

The second contact 38 is connected to the analogue to digital converter 32 and is configured to electrically connect to a data recorder (for example, in a plug and socket arrangement). The second contact 38 may also be connected to the memory 14.

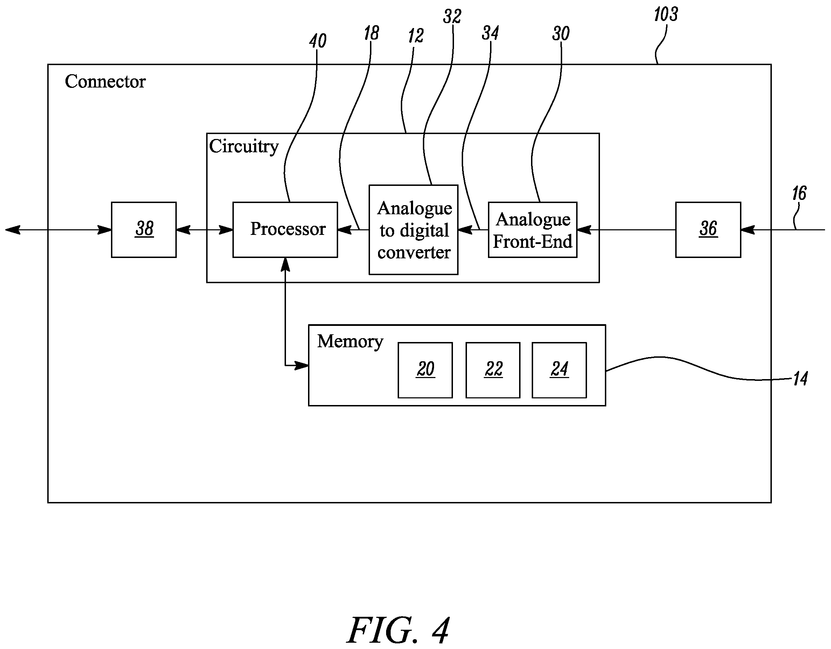

FIG. 4 illustrates a diagram of a connector 103 for connecting a sensor to a data recorder according to a fourth example. The connector 103 is similar to the connectors 10, 101, 102 and where the features are similar, the same reference numerals are used. The connector 103 includes circuitry 12, memory 14, a first contact 36, and a second contact 38. The circuitry 12 comprises an analogue front-end 30, an analogue to digital converter 32 and a processor 40. The memory 14 stores one or more of: sensor configuration data 20; or sensor calibration data 22, and may also store sensor history data 24.

The processor 40 may comprise any suitable processor circuitry and may comprise, for example, a field programmable gate array (FPGA), an application specific integrated circuit (ASIC), or a microcontroller. The processor 40 is connected to the analogue to digital converter 32, the memory 14 and to the second contact 38. The processor 40 is configured to receive the digital signal 18 from the analogue to digital converter 32 and to provide the processed digital signal to the data recorder via the second contact 38. The processor 40 may be configured to read from, and write to the memory 14 and may, for example, be configured to write sensor history data 24 to the memory 14. The processor 40 may also be configured to process the digital signal 18 (for example, by performing engineering unit conversion, or by checking the amplitude/frequency content of the signal against limits).

FIG. 5 illustrates a diagram of a connector 104 for connecting a sensor to a data recorder according to a fifth example. The connector 104 is similar to the connectors 10, 101, 102, 103 and where the features are similar, the same reference numerals are used. The connector 104 includes circuitry 12, memory 14, a first contact 36, a second contact 38 and a housing 42. The circuitry 12 may have the same structure as the circuitry 12 illustrated in any of FIGS. 1 to 4 and described in the preceding paragraphs. The memory 14 stores one or more of: sensor configuration data 20; or sensor calibration data 22, and may also store sensor history data 24.

The housing 42 may have any suitable shape and dimensions for housing the circuitry 12 and the memory 14. For example, the housing 42 may be cylindrical or cuboid. The housing 42 may also be shaped to be at least partially received within a socket of the data recorder. The housing 42 defines a cavity 44, a first aperture 46 and a second aperture 48. The circuitry 12 and the memory 14 are positioned within the cavity 44 of the housing 42. The first contact 36 may be positioned at least partially within the first aperture 46, or may be positioned wholly within the cavity 44, or may be positioned externally of the housing 42 (that is, wholly outside of the cavity 44 and the first aperture 46). The second contact 38 may be positioned at least partially within the second aperture 48, or may be positioned wholly within the cavity 44, or may be positioned externally of the housing 42 (that is, wholly outside of the cavity 44 and the second aperture 46).

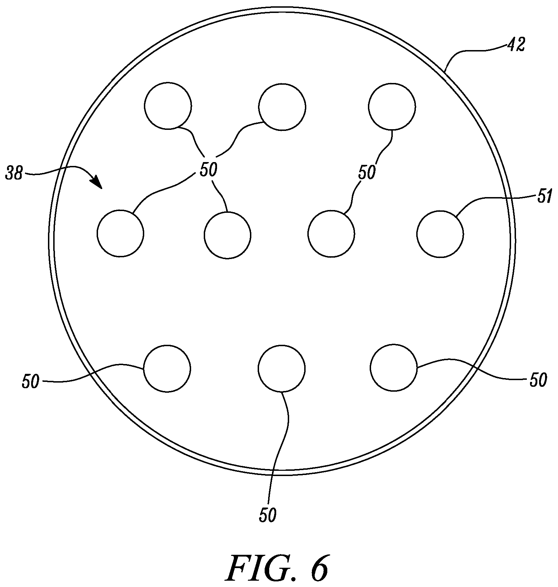

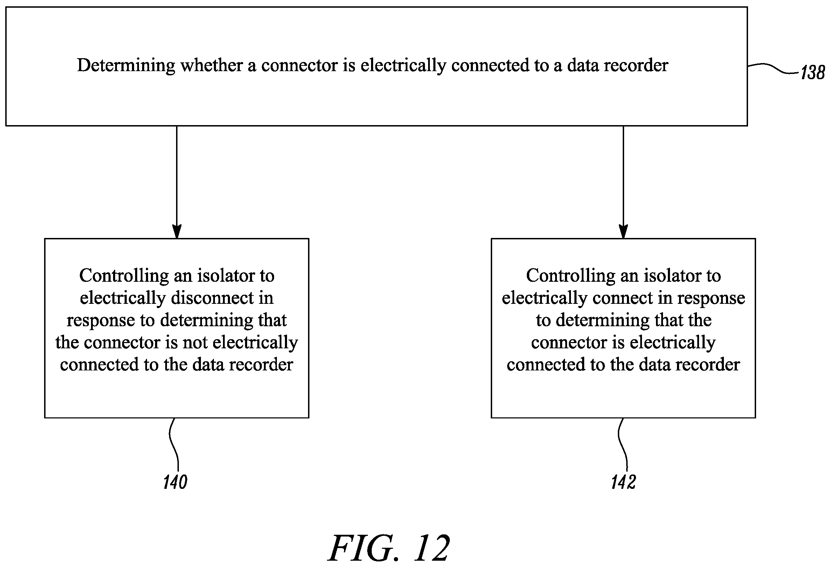

FIG. 6 illustrates a front view of the second contact 38 of the connector 104 according to an example. The second contact 38 comprises a plurality of contact pins 50 that are configured to electrically connect to the data recorder. The contact pins 50 may enable various functions to be performed by one or more of: the data recorder or the connector 104. For example, the contact pins 50 may enable an excitation voltage to be applied to the connector 104, may enable the connector 104 to be connected to ground, may enable communication between the data recorder and the circuitry 12, and may enable communication between the data recorder and the memory 14. As described in greater detail below with reference to FIG. 12, at least one contact pin 51 of the plurality of contact pins 50 may be configured to confirm an electrical connection between the data recorder and the connector 104.

FIG. 7 illustrates a diagram of a hub 52 according to an example. The hub 52 is configured to connect a plurality of sensors to a data recorder and includes a housing 54, a first connector 10, 101, 102, 103, a second connector 10, 101, 102, 103, and a bus extender 60.

The housing 54 may have suitable shape and dimensions and defines a cavity 62. The first connector 10, 101, 102, 103, the second connector 10, 101, 102, 103, and the bus extender 60 are positioned within the cavity 62. The bus extender 60 is connected to the first connector 10, 101, 102, 103, and to the second connector 10, 101, 102, 103. It should be appreciated that the hub 52 may comprise more than two connectors 10, 101, 102, 103 connected to one or more bus extenders.

The first connector 10, 101, 102, 103 is configured to receive a first signal 64 from a first sensor and to provide a first digital signal 66 to the bus extender 60. The second connector 10, 101, 102, 103 is configured to receive a second signal 68 from a second sensor and to provide a second digital signal 70 to the bus extender 60.

The bus extender 60 is configured to receive the first and second digital signals 66, 70 and to transmit them to the data recorder via a hub connector as indicated by arrow 72. The hub connector may be connected to the bus extender 60 via a cable, or may be directly connected to the bus extender 60.

FIG. 8 illustrates a diagram of a data recorder 74 according to an example. The data recorder 74 includes at least one processor 76, at least one memory 78, a contact 80 and may also include an isolator 82 and a transmitter 84.

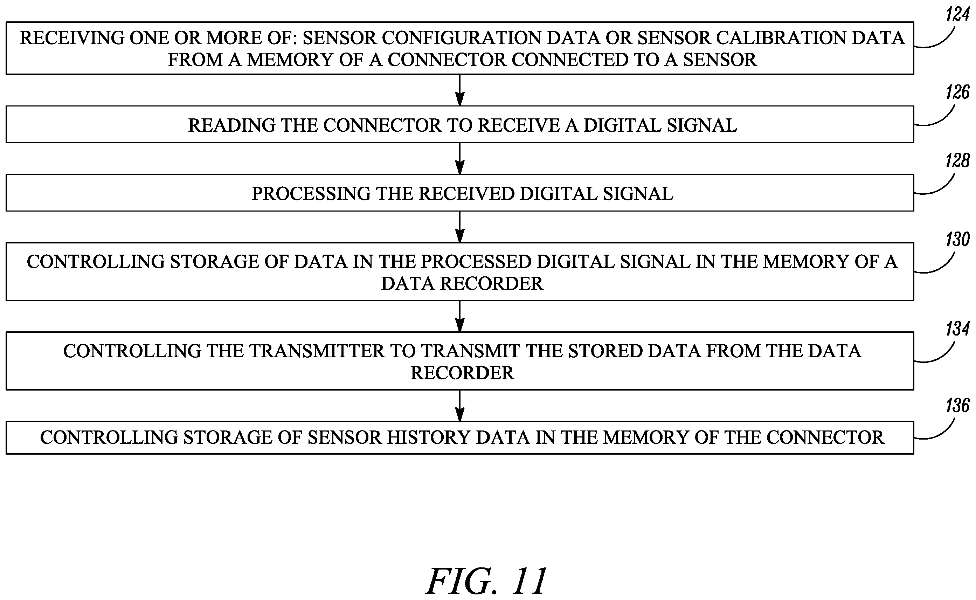

The processor 76 may comprise any suitable circuitry to cause performance of the methods described herein and as illustrated in FIGS. 11 and 12. The processor 76 may comprise: control circuitry; and/or processor circuitry; and/or at least one application specific integrated circuit (ASIC); and/or at least one field programmable gate array (FPGA); and/or single or multi-processor architectures; and/or sequential/parallel architectures; and/or at least one programmable logic controllers (PLCs); and/or at least one microprocessor; and/or at least one microcontroller; and/or a central processing unit (CPU); and/or a graphics processing unit (GPU), to perform the methods.

The memory 78 stores a computer program 86 comprising computer readable instructions that, when read by the processor 76, causes performance of the methods described herein, and as illustrated in FIGS. 11 and 12. The computer program 86 may be software or firmware, or may be a combination of software and firmware.

The memory 78 may be any suitable non-transitory computer readable storage medium, data storage device or devices, and may comprise a hard disk and/or solid-state memory (such as flash memory). The memory 78 may include one or more of: permanent non-removable memory, or removable memory (such as a universal serial bus (USB) flash drive or a secure digital card) (that is, the at least one memory 78 may be hand removable from the data recorder 74 by a person). The memory 78 may include: local memory employed during actual execution of the computer program 86; bulk storage; and cache memories which provide temporary storage of at least some computer readable or computer usable program code to reduce the number of times code may be retrieved from bulk storage during execution of the code.

The computer program 86 may be stored on a non-transitory computer readable storage medium 88. The computer program 86 may be transferred from the non-transitory computer readable storage medium 88 to the memory 78. The non-transitory computer readable storage medium 88 may be, for example, a USB flash drive, a secure digital (SD) card, an optical disc (such as a compact disc (CD), a digital versatile disc (DVD) or a Blu-ray disc). In some examples, the computer program 86 may be transferred to the memory 78 via a signal 90 (such as a wireless signal or a wired signal).

Input/output devices may be coupled to the processor 76 either directly or through intervening input/output controllers. Various communication adaptors may also be coupled to the processor 76 to enable the data recorder 74 to become coupled to other apparatus or remote printers or storage devices through intervening private or public networks. Nonlimiting examples include modems and network adaptors of such communication adaptors.

The contact 80 is configured to connect to the connector 10, 101, 102, 103, 104. For example, the contact 80 may comprise a plurality of sockets that are configured to receive the plurality of pins 50 illustrated in FIG. 6. The contact 80 may also be configured to connect to the hub 52 via a hub connector. The contact 80 is connected to the processor 76 and may also be connected to the processor 76 via the isolator 82.

The isolator 82 is connected to the processor 76 and to the contact 80. The isolator 82 may be any suitable isolator that is configurable to isolate the contact 80 from the processor 76. For example, the isolator 82 may be a mechanical switching device that, in an open position, allows for isolation of the contact 80 of the data recorder 74. In another example, the isolator 82 may be a digital isolator that comprises an integrated circuit that is configured to isolate digital signals across an isolation barrier. The processor 76 is configured to control the isolator 82 to isolate the contact 80.

It should be appreciated that the data recorder 74 may comprise a plurality of contacts 80, connected to the processor 76, to enable the data recorder 74 to be connected to a plurality of sensors. At least one of the plurality of contacts 80 may be connected to the processor 76 via an isolator (as illustrated in FIG. 8).

The transmitter 84 is configured to transmit data from the data recorder 74. The transmitter 84 may comprise any suitable circuitry (such as an integrated circuit) and may comprise one or more antennae to enable wireless transmission, or may comprise a communication port to enable connection to a cable to enable wired transmission. In some examples, the transmitter 84 may comprise receiver circuitry and in these examples, the transmitter 84 may be referred to as a transceiver. The processor 76 is configured to control the transmitter 84 to transmit data from the data recorder 74.

FIG. 9 illustrates a diagram of a system 92 according to an example. The system 92 includes the data recorder 74, the connector 104, the hub 52, a hub connector 94, a first sensor 96, a second sensor 98, a third sensor 110, a first cable 112, a second cable 114, a third cable 116, a fourth cable 118 and an electrical energy storage device 119.

The first sensor 96, the second sensor 98 and the third sensor 110 may be any suitable sensors for measuring one or more parameters of a propulsion system. As used herein, a 'parameter' of a propulsion system refers to any characteristic that can help in defining or classifying the propulsion system. In other words, a 'parameter' of the propulsion system may be a numerical or other measurable factor that forms a set with other such parameters that define the conditions of operation of the propulsion system. Such parameters may include mechanical parameters (component speeds, vibrations and strains, for example), electrical parameters (potential differences and currents, for example), and thermodynamic parameters (temperatures and pressures at different locations, for example).

For example, the first sensor 96 may be a pressure sensor that is configured to monitor a pressure at a first location of a gas turbine engine, the second sensor 98 may be a thermocouple that is configured to monitor a temperature at a second location of the gas turbine engine, and the third sensor 110 may be a vibration sensor that is configured to monitor vibration at a third location of the gas turbine engine. The first, second and third locations may be different to one another, may be the same as one another, or one of the first, second and third locations may be different to the other two locations.

The first sensor 96 is connected to the data recorder 74 via the first cable 112, the hub 52, the second cable 114 and the hub connector 94. The first cable 112 is connected to the first sensor 96 and to the first connector 10, 101, 102, 103 of the hub 52. The second cable 114 is connected to the bus extender 60 of the hub 52 and to hub connector 94. A contact 80 of the data recorder 74 is connected to the hub connector 94.

The second sensor 98 is connected to the data recorder 74 via the third cable 116, the hub 52, the second cable 114 and the hub connector 94. The third cable 116 is connected to the second sensor 98 and to the second connector 10, 101, 102, 103 of the hub 52. As mentioned in the preceding paragraph, the second cable 114 is connected to the bus extender 60 of the hub 52 and to the hub connector 94, and a contact 80 of the data recorder 74 is connected to the hub connector 94.

The third sensor 110 is connected to the data recorder 74 via the fourth cable 118 and the connector 104. The fourth cable 118 is connected to the third sensor 110 and to the first contact 36 of the connector 104. The second contact 38 of the connector 104 is connected to a contact 80 of the data recorder 74.

The electrical energy storage device 119 is configured to supply electricity to the components of the system 92. For example, the electrical energy storage device 119 may supply electricity to the data recorder 74, and the data recorder 74 may distribute the electricity to the connector 104, the hub connector 94, the hub 52, first sensor 96, the second sensor 98 and the third sensor 110. The electrical energy storage device 119 may be any suitable device and comprise a battery or a supercapacitor.

It should be appreciated that the system 92 may comprise any number of sensors (including a single sensor) and that three sensors are illustrated in FIG. 9 as an example only. Similarly, the system 92 may comprise more than one connector 104 and more than one hub 52. In some examples, the system 92 may comprise one or more hubs 52, but may not include any of the connectors 104. In other examples, the system 92 may comprise one or more connectors 104, but may not include any hubs 52.

It should be appreciated from FIG. 9 that the hub 52 may advantageously enable an increase in the number of sensors, and types of sensors, that may be connected to the data recorder 74 without requiring a change in the interface of the data recorder 74.

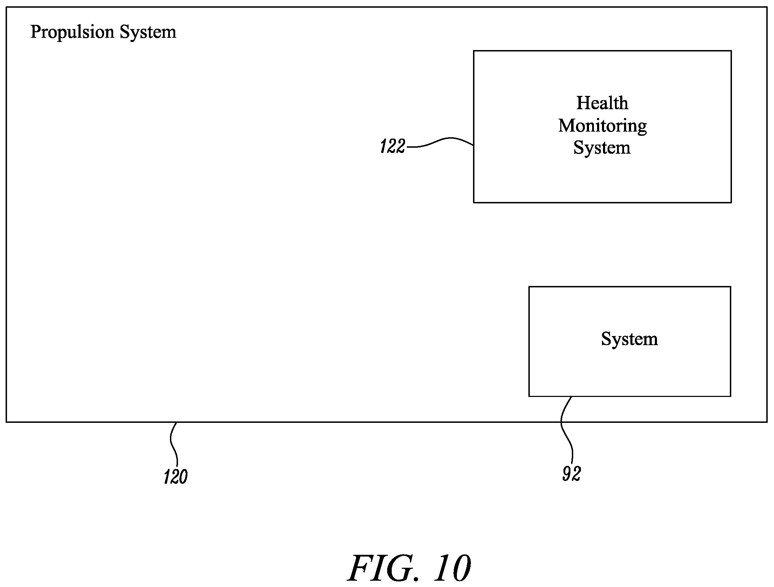

FIG. 10 illustrates a diagram of a propulsion system 120 comprising a system 92 according to an example. The propulsion system 120 may comprise one or more of: gas turbine engines; or one or more reciprocating engines; or one or more electrical motors. The propulsion system 120 may be coupled to a vehicle to provide thrust and/or electrical power to the vehicle. Examples of vehicles include aircraft, automobiles, watercraft and locomotives.

The propulsion system 120 may also comprise a health monitoring system 122. The health monitoring system 122 is configured to generate data for a plurality of parameters of the propulsion system 120. The system 92 is also configured to generate data for one or more parameters of the propulsion system 120. However, at least one of the one or more parameters to be monitored by the system 92 may be different to the plurality of parameters to be monitored by the health monitoring system 122. In other words, the system 92 may be configured to monitor at least one parameter of the propulsion system 120 that the health monitoring system 122 is unable to monitor.

The deployment of the system 92 may take less time than the deployment of the health monitoring system 122. Similarly, the removal of the system 92 may take less time than the removal of the health monitoring system 122. For example, where the health monitoring system 122 and the system 92 are coupled to the propulsion system 120 via fasteners (such as nuts and bolts for example), the system 92 may require fewer fasteners to be fastened and unfastened than the health monitoring system 122.

By way of another example, where the health monitoring system 122 and the system 92 are mounted to the propulsion system 120, the system 92 may be mounted at a more accessible location than the health monitoring system 122, thus enabling faster deployment and removal. By way of a further example, the system 92 may have fewer electrical connections to disconnect than the health monitoring system 122 and may consequently take less time to deploy and remove than the health monitoring system 122. In some examples, the deployment and/or removal of the system 92 may take less time than the deployment and/or removal of the health monitoring system 122 due to the system 92 requiring a lower level of clearance (for example, a lower amount paperwork and process) than the health monitoring system 122. The system 92 may be referred to as a troubleshooting kit.

FIG. 11 illustrates a flow diagram of a method according to a first example. At block 124, the method includes receiving one or more of: sensor configuration data or sensor calibration data from a memory of a connector connected to a sensor. For example, the data recorder 74 may receive one or more of: sensor configuration data 20 or sensor calibration data 22 from the memory 14 of the connector 10, 101, 102, 103, 104 (or the hub 52) connected to the sensor 96, 98, 110. In some examples, block 124 may additionally include receiving sensor history data from the memory of the connector. For example, the data recorder 74 may receive sensor history data 24 from the memory 14 of the connector 10, 101, 102, 103, 104 (or the hub 52).

At block 126, the method includes reading the connector to receive a digital signal. Where block 124 includes receiving sensor configuration data, block 126 may comprise reading the connector using the received sensor configuration data to receive the digital signal. For example, the processor 76 of the data recorder 74 may use the received sensor configuration data 20 to read the connector 10, 101, 102, 103, 104 (or the hub 52) to receive the digital signal 18, 72.

At block 128, the method includes processing the received digital signal. Where block 124 includes receiving sensor calibration data, block 128 may comprise processing the received digital signal using the received sensor calibration data. For example, the processor 76 of the data recorder 74 may use the received sensor calibration data 22 to process the received digital signal.

At block 130, the method includes controlling storage of data in the processed digital signal in the memory of a data recorder. For example, the processor 76 of the data recorder 74 may control the storage of data in the processed digital signal in the memory 78 of the data recorder 74 (labelled with reference numeral 132 in FIG. 8). In the example of FIG. 9, block 130 may comprise controlling the storage of pressure data, temperature data and vibration data in the memory 78.

At block 134, the method includes controlling a transmitter to transmit the stored data from the data recorder. For example, the processor 76 of the data recorder 74 may control the transmitter 84 to transmit the stored data 132 from the data recorder 74 (for example, as a wireless signal).

At block 136, the method includes controlling storage of sensor history data in the memory of the connector. For example, the processor 76 of the data recorder 74 may control the storage of sensor history data (a date on which sensor calibration data was created for example) in the memory 14 of the connector 10, 101, 102, 103, 104 (or of the hub 52). In some examples, the processor 40 of the connector 103 may control the storage of sensor history data in the memory 14 of the connector 103.

The system 92, and the components of the system 92 (such as the connector 10, 101, 102, 103, 104) may provide several advantages.

The system 92 may be relatively quick to setup. In particular, a sensor of the system 92 may not require any manual configuration or calibration by a person because the data recorder 74 may read the sensor configuration data 20 and the sensor calibration data 22 when the connector 10, 101, 102, 103, 104 is connected to the data recorder 74. This may facilitate a change between different sensor types and between transient and dynamic data recording at the data recorder 74.

Additionally, the connector 10, 101, 102, 103, 104 and the hub 52 may be manufactured, calibrated, and configured in the same facility, or by the same manufacturer, and this may enable higher quality control and lower lifecycle cost.

The analogue front end 30, the analogue to digital converter 32 and the processor 40 may advantageously offload processing away from the data recorder 74 and reduce the processing workload of the processor 76.

As mentioned above, the system 92 may enable one or more parameters of the propulsion system 120 to be monitored that cannot be monitored by the health monitoring system 122. This is advantageous when a fault occurs with the propulsion system 120 and the data being received from the health monitoring system 122 does not enable diagnosis of the fault.

The ability to rapidly deploy and remove the system 92 as needed or desired may also be advantageous in that it may enable the minimalization of the health monitoring system 122. In particular, the sensor array of the health monitoring system 122 may be configured to only have sensors for essential parameters, and the system 92 may be deployed when it is desired to monitor non-essential parameters.

Furthermore, the ability to rapidly deploy and remove the system 92 as needed or desired may be advantageous in that it may performed while the propulsion system 120 is mounted on a vehicle (that is, the deployment and removal may be performed in-situ). This may help to maximize the availability of the vehicle for operations.

The provision of a dedicated processor 76 for the system 92 may be advantageous in that the processor 76 may not be required to comply with a high design assurance level (such as design assurance level A (DAL-A)). This may enable a higher processing power and commercial off the shelf (COTS) processor to be used for the processor 76. Such a processor may be able to perform a wider variety of calculations (including more demanding algorithms such as machine learning algorithms) and may be less costly than the processor of the health monitoring system 122.

The memory 78 being removable and hand portable may be advantageous in that such memory may enable the rapid transfer of the data 132 stored on the memory 78. For example, a person at an airport may relatively quickly remove the memory 78, without removing any other components of the system 92, and transfer the data 132 to another computer (a laptop for example). This process may take less time than one in which the data is transferred to a computer via a cable.

The provision of a wireless transmitter 84 may be advantageous in that such a transmitter may enable the rapid transfer of the data 132 stored on the memory 78. For example, the data 132 may be transferred automatically and wirelessly upon the transmitter 84 coming into range of a receiver at an airport. This process may take less time than one in which the data 132 is transferred to a computer via a cable, or via a removable memory as described in the preceding paragraph.

The electrical energy storage device 119 may advantageously supply electrical energy to the components of the system 92. Consequently, the system 92 may operate independently to the propulsion system 120 and to the health monitoring system 122. Additionally, as the system 92 does not need to be electrically connected to an electrical power supply of the propulsion system 120, the system 92 may be faster to deploy and remove relative to the health monitoring system 122 (which may be connected to an electrical power supply of the propulsion system 120).

FIG. 12 illustrates a flow diagram of a method according to a second example.

At block 138, the method includes determining whether a connector is electrically connected to a data recorder. For example, the processor 76 of the data recorder 74 may control the application of a voltage to the contact 80 (represented by arrow 139 illustrated in FIG. 8) to determine whether current flows to the pin 51 of the second contact 38. Where the processor 76 determines a flow of current, the processor 76 determines that an electrical connection exists between the data recorder 74 and the connector 104. Where the processor 76 determines that no current flows, the processor 76 determines that an electrical connection does not exist between the data recorder 74 and the connector 104.

At block 140, the method includes controlling an isolator to electrically disconnect in response to determining that the connector is not electrically connected to the data recorder. For example, the processor 76 of the data recorder 74 may control the isolator 82 to electrically disconnect in response to determining that the connector 104 is not electrically connected to the data recorder 74 (for example, by determining that the pin 51 is not present). In this configuration, the isolator 82 isolates the processor 76 from the connected connector 10, 101, 102, 103, 104 or hub 52.

At block 142, the method includes controlling an isolator to electrically connect in response to determining that the connector is electrically connected to the data recorder. For example, the processor 76 of the data recorder 74 may control the isolator 82 to electrically connect in response to determining that the connector 104 is electrically connected to the data recorder 74 (for example, by determining that the pin 51 is present). In this configuration, the isolator 82 allows the flow of data from the connector 10, 101, 102, 103, 104 and the hub 52 to the processor 76.

The method illustrated in FIG. 12 and described above may advantageously enable the processor 76 to place the interface of the data recorder 74 (that is, the one or more connectors 80) into a protected state when it is open.

Various examples have been described, each of which comprise one or more combinations of features. It will be appreciated by those skilled in the art that, except where clearly mutually exclusive, any of the features may be employed separately or in combination with any other features and the invention extends to and includes all combinations and sub-combinations of one or more features described herein.

## Claims

1. A data recorder comprising:
at least one processor;
at least one memory comprising computer readable instructions;
the at least one processor being configured to read the computer readable instructions to cause performance of:
receiving one or more of: sensor configuration data; or sensor calibration data from a memory of a connector connected between the data recorder and a sensor;
reading the connector to receive a digital signal;
processing the received digital signal; and
controlling storage of data in the processed digital signal in the at least one memory of the data recorder.

2. The data recorder as claimed in claim 1, wherein reading the connector comprises reading the connector using the received sensor configuration data to receive the digital signal.

3. The data recorder as claimed in claim 1 or 2, wherein processing the received digital signal comprises processing the received digital signal using the received sensor calibration data.

4. The data recorder as claimed in any of the preceding claims, further comprising controlling storage of sensor history data in the memory of the connector.

5. The data recorder as claimed in any of the preceding claims, wherein the data recorder further comprises an isolator configured to electrically connect to the connector.

6. The data recorder as claimed in claim 5, wherein the at least one processor is configured to read the computer readable instructions to cause performance of:
determining whether the connector is electrically connected to the data recorder;
controlling the isolator to electrically disconnect in response to determining that the connector is not electrically connected to the data recorder; and
controlling the isolator to electrically connect in response to determining that the connector is electrically connected to the data recorder.

7. A system comprising:
the data recorder as claimed in any of the preceding claims; and
a connector connecting a sensor to the data recorder, the connector comprising:
circuitry configured to receive a signal from the sensor and to transmit a digital signal to the data recorder; and
a memory storing the one or more of: the sensor configuration data; or the sensor calibration data.

8. The system of claim 7, wherein the circuitry of the connector comprises:
an analogue front-end configured to: receive an analogue signal from the sensor, and perform signal conditioning on the analogue signal; and
an analogue to digital converter configured to: receive the conditioned analogue signal from the analogue front-end, and convert the conditioned analogue signal into the digital signal.

9. The system as claimed in claim 8, wherein the connector further comprises a first contact connected to the analogue front-end, the first contact being connected to the sensor via a cable.

10. The system as claimed in claim 8 or 9, wherein the connector further comprises a second contact connected to the analogue to digital converter, and to the memory, the second contact being configured to electrically connect to the data recorder.

11. The system as claimed in claim 8 or 9, wherein the circuitry further comprises a processor connected to the analogue to digital converter and to the memory; and the connector further comprises a second contact connected to the processor.

12. The system as claimed in claim 10 or 11, wherein the second contact comprises a plurality of contact pins electrically connected to the data recorder and at least one contact pin of the plurality of contact pins being configured to confirm an electrical connection between the data recorder and the connector.

13. The system as claimed in any of claims 7 to 12, further comprising a housing defining a cavity, the circuitry and the memory of the connector being positioned within the cavity of the housing of the connector.

14. The system as claimed in any of claims 7 to 13, further comprising: a hub comprising:
a housing defining a cavity; and
a plurality of connectors, the plurality of connectors being positioned within the cavity of the housing of the hub, each of the plurality of connectors comprising:
circuitry configured to receive a signal from the sensor and to transmit a digital signal to the data recorder; and
a memory storing the one or more of: the sensor configuration data; or the sensor calibration data.

15. A propulsion system comprising the system as claimed in any of claims 7 to 14.
